# EUROPEAN PATENT APPLICATION

(11) **EP 2 341 536 A2**
(43) Date of publication of application: **06.07.2011**
(21) Application number: 10195070.7
(22) Date of filing: 15.12.2010
(51) Int. Cl.: H01L 25/075, F21K 99/00

(54) **Lighting apparatus**

(30) Priority: 24.12.2009 JP 2009293411
(71) Applicant: Toshiba Lighting & Technology Corporation, Yokosuka-shi Kanagawa 237-8510 (JP); Kabushiki Kaisha Toshiba, Minato-ku, Tokyo 105-8001 (JP)
(72) Inventor: Nishimura, Kiyoshi, Kanagawa 237-8510 (JP); Oyaizu, Tsuyoshi, Kanagawa 237-8510 (JP); Ogawa, Kozo, Kanagawa 237-8510 (JP)
(74) Representative: Kramer - Barske - Schmidtchen

(57) **Abstract**

According to one embodiment, a lighting apparatus includes a conductive main body at a ground potential, a light-emitting device (1) in the main body, and a lighting control device configured to supply power to the light-emitting device. The light-emitting device includes a substrate (2) including an insulation layer (22), and a radiation layer (23) with a thermal conductivity, formed of conductive material and laminated on the insulation layer, a plurality of light-emitting elements (3) mounted on the radiation layer, and a power supply wiring (4) configured to electrically connect the light-emitting elements and to make the radiation layer electrically nonconductive.

## Description

### FIELD

Embodiments described herein relate generally to lighting apparatus using a light-emitting element such as a light-emitting diode (LED).

### BACKGROUND

A light-emitting diode has recently been used as a light source of lighting apparatus. In such a light source, a plurality of bare LED chips is mounted on a substrate, and each LED chip is electrically connected to a wiring pattern by a bonding wire. A plurality of such substrates is housed in a main body made of metal such as aluminum. Such lighting apparatus is usually powered by a lighting control device connected to an alternating-current source, and lighting of LED chips is controlled. The metal main body is maintained at a ground potential.

However, in the above-mentioned lighting apparatus, though a power switch (one-position) of the lighting control device is turned off, the LED chips may faintly light dusky. This erroneous lighting of the LED chips is caused by a noise superimposed on a power line. Stray capacitance is generated between a conductor such as the wiring pattern connected to the LED chips and the metallic main body close to the conductor, and a minute current as a leakage current flows in the LED chips.

As a method of preventing the erroneous lighting, a capacitor serving as a bypass element is connected in parallel to each LED chip to form a bypass for the minute current. However, with this method, the manufacturing cost is increased by adding the capacitors, and reliability of the wiring connection deteriorates due to increasing the number of parts to be soldered. Further, when the capacitors are mounted on the surface of the substrate, the reflectivity of the substrate surface is reduced, and an optical output of the light source is decreased.

As a temperature of a light-emitting element such as an LED rises, the optical output is decreased, and a service life is reduced. Therefore, a lighting apparatus using a solid light-emitting element such as an LED and EL element as the light source needs to prevent a temperature rise in the light-emitting element for increasing the service life and improving the luminous efficiency.

### BRIEF DESCRIPTION OF THE DRAWINGS

FIG. 1 is an exemplary plan view of a light emitting device of a lightning apparatus according to a first embodiment;
FIG. 2 is an exemplary plan view of the light emitting device with a frame member and a sealing member removed;
FIG. 3 is an exemplary sectional view taken along line III-III in FIG. 1;
FIG. 4 is an exemplary connection diagram schematically showing the lighting apparatus according to the first embodiment;
FIG. 5 is an exemplary plan view of a light emitting device of a lighting apparatus according to a second embodiment;
FIG. 6 is an exemplary plan view of the light emitting device with a frame member and a sealing member removed; and
FIG. 7 is an exemplary sectional view along line VII-VII in FIG. 5.

### DETAILED DESCRIPTION

In general, according to one embodiment, a lighting apparatus comprises: a conductive main body at a ground potential; a light-emitting device in the main body; and a lighting control device configured to supply power to the light-emitting device. The light-emitting device comprises a substrate comprising an insulation layer, and a radiation layer with a thermal conductivity, formed of conductive material and laminated on the insulation layer; a plurality of light-emitting elements mounted on the radiation layer; and a power supply wiring configured to electrically connect the light-emitting elements and to make the radiation layer electrically nonconductive.

A substrate preferably uses metallic material with a high thermal conductivity and efficient radiation, such as aluminum, as a base plate. However, material is not limited to this. As an insulating material of a base plate, ceramic or synthetic resin with high durability and efficient radiation may be used. A light-emitting element is a solid light-emitting element such as a light-emitting diode (LED). The number of light-emitting elements to be mounted on the substrate is not limited.

A radiation layer is formed of three layers, for example. A first layer is etched with copper. The copper layer is plated with nickel (Ni) as a second layer. The nickel-plated layer is plated with silver (Ag) as a third layer. In this case, the surface layer can be highly reflective. A power supply wiring means a conductor such as a bonding wire or a wiring pattern for electrically connecting each light-emitting element.

Lighting apparatus includes a lighting equipment to be used indoor or outdoor, a display unit, and the like.

According to one embodiment, the power supply wiring for electrically connecting the light-emitting element comprises bonding wires electrically connecting electrodes of adjacent light-emitting elements to each other.

In the above configuration, electrodes of adjacent light-emitting elements are directly connected to each other by a bonding wire. The bonding wire is preferably a gold (Au) thin wire, but may be other metallic wires.

According to one embodiment, the power supply wiring for electrically connecting the light-emitting element comprises a connection conductor smaller than at least an area of the radiation layer located between adjacent light-emitting elements, and bonding wires electrically connecting electrodes of adjacent light-emitting elements to each other through the connection conductor.

The connection conductor preferably has an area smaller than at least the radiation layer, and minimal for connecting a bonding wire.

According to one embodiment, there is provided a lighting apparatus, which effectively prevents a temperature increase of a light-emitting element by increasing the area of a radiation layer, and prevents erroneous lighting of the light-emitting element by decreasing the area of the power supply wiring.

According to one embodiment, in addition to the above effect, as the electrodes of adjacent light-emitting elements are connected by a bonding wire, the area of a power supply wiring can be reduced. Further, as the electrodes of adjacent light-emitting elements are connected by a bonding wire through a connection conductor having a small area, the area of a power supply wiring can be reduced.

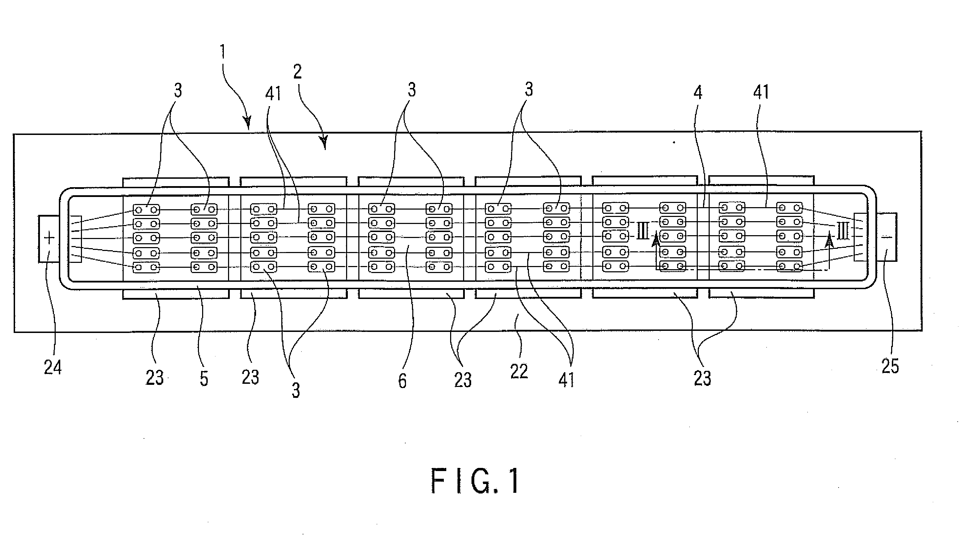

Hereinafter, a lighting apparatus comprising a light-emitting device according to a first embodiment will be explained with reference to FIGS. 1 to 4. The same parts in the drawings are given the same reference number, and a repeated explanation thereof will be omitted.

As shown in FIGS. 1 to 3, a light-emitting device 1 of a lighting apparatus comprises a substrate 2, light-emitting elements 3, a power supply wiring 4 connected to an electrode of each light-emitting element, a frame member 5, and a sealing member 6.

The substrate 2 is formed in substantially rectangular. The substrate 2 comprises a base plate 21 made of metallic material with a high thermal conductivity and efficient radiation, such as aluminum, to increase radiation of each light-emitting element 3, and an insulation layer 22 laminated evenly on the base plate 21. The insulation layer 22 is formed of electrically insulative organic synthetic resin, for example, epoxy resign. The base plate 21 may be formed of insulating material such as ceramic or synthetic resin with high durability and relatively efficient radiation.

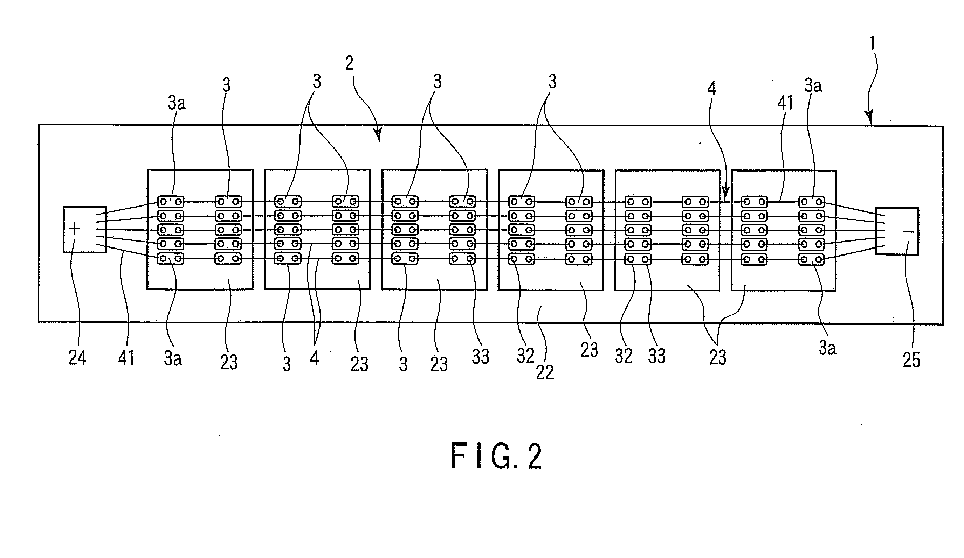

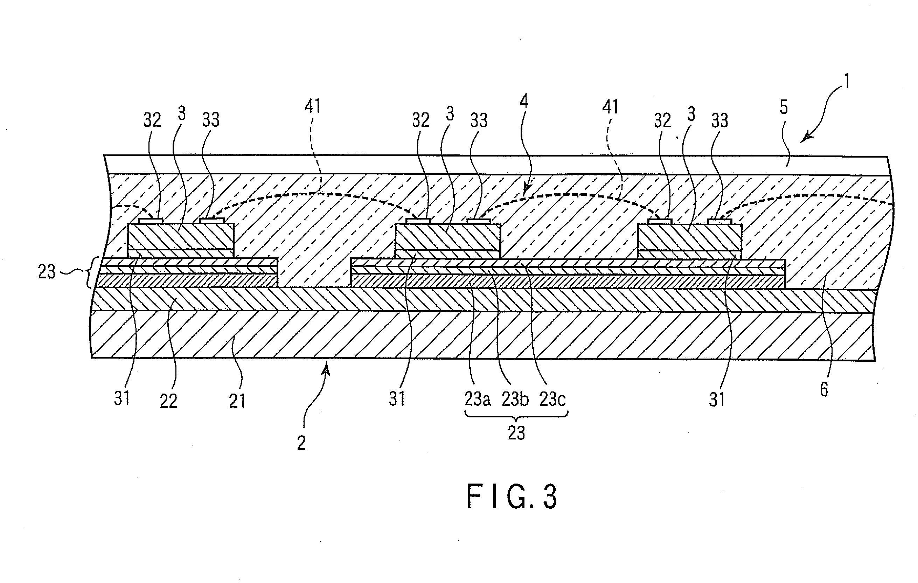

As shown in FIGS. 2 and 3, on the insulation layer 22, a plurality of radiation layers 23, a positive power supply conductor 24, and a negative power supply conductor 25 are laminated in a similar laminar structure. As shown in FIG. 2, the radiation layers 23 are formed in six substantially rectangular blocks, which are arranged in the longitudinal direction of the substrate 2 with intervals. The positive power supply conductor 24 and negative power supply conductor 25 are provided at both ends in the longitudinal direction of the substrate 2, as a pair, and are spaced a predetermined insulation distance from the radiation layers 23.

As shown in FIG. 3, the radiation layers 23, positive power supply conductor 24, and negative power supply conductor 25 have a three layered structure, in which a first layer 23a, a second layer 23b, and a third layer 23c are sequentially stacked. The first layer 23a is a copper foil pattern formed on the insulation layer 22 by etching. The second layer 23b is a nickel (Ni) layer plated on the copper foil pattern. The third layer 23c is a silver (Ag) layer plated on the nickel layer 23b. The third layer 23c, i.e., the surface layer of each of the radiation layer 23, and the positive and negative power supply conductors 24 and 25 are plated with metal such as silver (Ag), and the total light reflectivity of the third layer is as high as 90%. On the insulation layer 22, a not-shown resist layer may be formed as appropriate.

The positive power supply conductor 24 and negative power supply conductor 25 are conductive layers electrically connected to other parts. Contrarily, the radiation layer 23 is a non-conductive layer not electrically connected to other parts.

Each of the light-emitting elements 3 uses a bare LED chip (LED chip). A chip configured to emit blue light, for example, is used as the LED chip 3, so that the light emitting device 1 emits white light. The LED chip 3 is bonded on each radiation layer 23 by using an insulative silicone resin adhesive 31.

The LED chip 3 is an InGaN element, for example, with a light-emitting layer formed on a translucent sapphire element substrate. The light-emitting layer is formed by sequentially laminating an n-type nitride semiconductor layer, an InGaN light-emitting layer, and a p-type nitride semiconductor layer. The LED chip 3 comprises electrodes for flowing a current to the light-emitting layer, which are a positive electrode 32 formed by a p-type electrode pad on the p-type nitride semiconductor layer, and a negative electrode 33 formed by a n-type electrode pad on the n-type nitride semiconductor layer.

The power supply wiring 4 is a conductor having a function of electrically connecting each LED chip 3. The electrodes 32 and 33 of the LED chip 3 are electrically and directly connected to the electrodes of other LED chips 3, or the positive power supply conductor 24 and negative power supply conductor 25, by bonding wires 41 as the power supply wiring 4. The bonding wire 41 is a gold (Au) thin wire, and is connected to the electrode or supply conductor through a bump made mainly of gold (Au) to increase the mounting strength and to decrease damages of the LED chip 3.

Ten LED chips 3 are mounted on each radiation layer 23 in two lines orthogonal to the longitudinal direction of the substrate 2. Two LED chips 3 aligned in the longitudinal direction on each radiation layer 23 are connected in series. Total twelve LED chips 3 aligned in the longitudinal direction of the substrate 2 are connected in series, and five series circuits are formed.

In particular, in each line of LED chips 3 aligned in the longitudinal direction of the substrate 2, the different polarity electrodes of LED chips 3 adjacent in the line extending direction, that is, the positive electrode 32 of one LED chip 3 and the negative electrode 33 of the other LED chip 3 are sequentially and directly connected by the bonding wire 41. Therefore, the LED chips 3 forming each line of LED chips are electrically connected in series, and are simultaneously lit when power is supplied.

In each line of LED chips 3, the electrode of a specific LED chip, that is, the LED chip 3a placed at the end of the line is connected to the positive power supply conductor 24 or negative power supply conductor 25 by the bonding wire 41. Therefore, the lines of LED chips 3 are electrically disposed in parallel, and are powered through the positive power supply conductor 24 and negative power supply conductor 25. Even if any one line of the LED chips 3 fails to emit light due to poor bonding, the whole light-emitting device 1 does not stop lighting.

As described above, the electrodes 32, 33 of adjacent LED chips 3 are directly connected by the bonding wires 41 as a power supply wiring 4, not through, e.g., a wiring pattern on the substrate 2. Therefore, an area of the conductor formed by the power supply wiring 4 is mainly defined by the bonding wire, and is a minimal area. In other words, as described later, the main body 8 at a ground potential forms one electrode, and the power supply wiring 4 forms the other electrode, and these electrodes are electrostatically coupled through a dielectric material therebetween, thereby generating a stray capacitance. In this case, the stray capacitance is proportional to the area of the electrode. As the electrode area defined by the power supply wiring 4 is small as described above, the stray capacitance can be decreased.

As shown in FIGS. 1 and 3, the frame member 5 is bonded to the substrate 2 by applying an uncured silicon resin of predetermined viscosity by means of a dispenser, and then hardening by heating. The frame member 5 has a substantially rectangular inner peripheral surface. Inside of the inner peripheral surface of the frame member are arranged the most part of the radiation layer 23, and the connecting portions of the positive and negative power supply conductors 24 and 25 connected to the bonding wires 41. In other words, the LED chip mounting area is surrounded by the frame member 5.

The frame member 5 is made of silicon resin as described above, and is hardly deteriorated by light and heat. This prevents discoloring of the silver plated radiation layer 23, positive power supply conductor 24, and negative power supply conductor 25. Thus, the frame member 5 suppresses deterioration of the reflectivity by the radiation layer 23, positive power supply conductor 24, and negative power supply conductor 25.

If the frame member 5 is formed of epoxy resin, organic matter adheres to the silver plated surface layer, and the plated surface layer is deteriorated and discolored, causing reduction of the reflectivity. The frame member 5 may be made of silicon resin mixed with titanium oxide. In this case, discoloration and deterioration of the surface of the radiation layer 23 by light can be further prevented.

The sealing member 6 is formed of transparent silicon resin, for example. The sealing member 6 is filled in the frame member 5, and is provided on the substrate 2. The sealing member 6 seals each LED chip 3 and the connecting portions of the positive and negative power supply conductors 24, 25 connected by the bonding wires 41.

The sealing member 6 contains the right amount of fluorescent material. The fluorescent material is excited by the light emitted from the LED chips 3, and emits light of the color different from the light emitted from the LED chip 3. In this embodiment, the LED chips 3 emit blue light, a yellow fluorescent material to emit yellow light that is a complementary color to the blue light is used, so that white light is emitted from the light-emitting device 1. Predetermined amount of uncured sealing member 6 is injected into the frame member 5, and then hardened by heating. Therefore, the sealing area of the sealing member 6 is defined by the frame member 5.

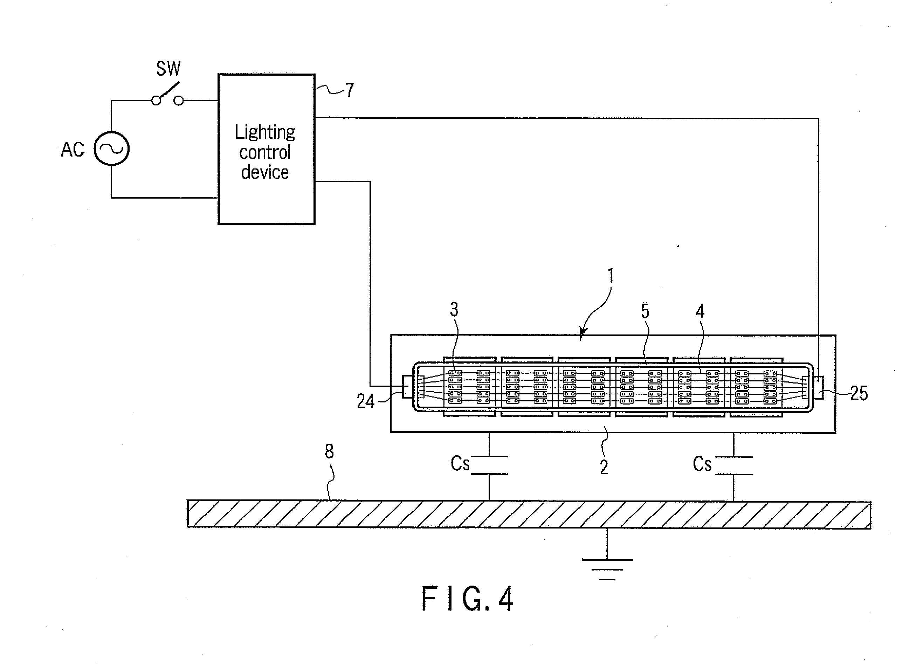

Next, the effect of the light-emitting device 1 configured as described above will be explained. FIG. 4 is a connection diagram schematically showing the lighting apparatus provided with the light-emitting device 1. The lighting apparatus comprises a lighting control device 7 connected to a commercial alternating-current source AC through a power switch SW and a main body 8 containing the light-emitting device 1. The lighting control device 7 is constructed by connecting a smoothing capacitor between the output terminals of a full-wave rectifier circuit, for example, and connecting a direct-current voltage converter circuit and a current detection means to the smoothing capacitor. The lighting control device 7 supplies a direct current to the light-emitting device 1 and controls lighting of the LED chips 3. The main body 8 is formed of conductive metal such as aluminum, and is maintained at a ground potential.

When the light-emitting device 1 is powered, the LED chips 3 covered by the sealing member 6 are simultaneously lit, and the light-emitting device 1 serves as a sheet shaped light source to emit white light. While the LED chips 3 are lighting, the radiation layer 23 functions as a heat spreader to spread the heat generated from each LED chip 3, and accelerates radiation. While the light-emitting device 1 is lighting, the light emitted from the LED chips 3 toward the substrate 2 is reflected on the radiation layers 23 and the surface layers of the positive power supply conductor 24 and negative power supply conductor 25, mainly in the direction of using the light.

When the power supply wiring connecting each LED chip 3 is placed close to the main body 8, or when the base plate 21 contacts the main body 8, the insulation layer 22 functions as a dielectric unit, and a stray capacitance Cs may be generated between the light-emitting device 1 and the main body 8.

Contrarily, in this embodiment, the area of the bonding wire 41 which serves as an electrode of the stray capacitance Cs is small, and the stray capacitance Cs can be reduced. Therefore, even if a noise is superimposed on a power supply line while the power switch SW is being turned off, a minute current is prevented from flowing in the LED chips 3 as a leakage current, and erroneous lighting of the LED chip 3s are prevented as a result.

In the lighting apparatus according to this embodiment, as a result of experiments of adding a power supply noise of 50Hz and 1Kv in amplitude, it is proved that if the stray capacitance Cs is controlled to 40pF, faint lighting of the LED chips 3 is difficult to detect. Therefore, it is confirmed that preferable stray capacitance Cs per one light-emitting device 1 is 40pF or lower.

Further, the radiation layer 23 to mount the LED chip 3 may be used as a wiring pattern. In this case, if the area of the radiation layer 23 is increased to enhance the radiation effect, the stray capacitance Cs tends to increase, and a leakage current caused by a noise flows in the LED chips 3, and the LED chips 3 may be erroneously lit.

In this embodiment, however, as the radiation layer 23 is not electrically connected to other parts and nonconductive, erroneous lighting of the LED chips 3 can be prevented by increasing the radiation effect of the LED chips 3 to a maximum by increasing the area of the radiation layer 23, and preventing a minute current flow in the LED chip 3 as a leakage current by decreasing the area of the power supply wiring means 4.

As described above, according to this embodiment, a temperature increase in the LED chips 3 can be effectively prevented by increasing the area of the radiation layer 23, and erroneous lighting of the light-emitting elements 3 can be prevented by decreasing the area of the power supply wiring 4. This makes it possible to provide a lighting apparatus, which prevents erroneous lighting of light-emitting elements, and enhances the radiation effect.

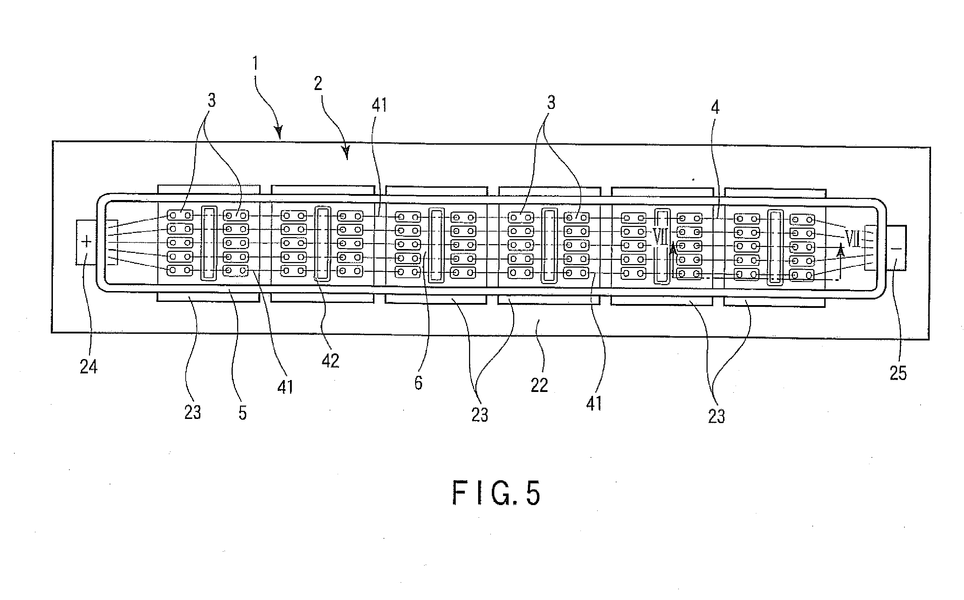

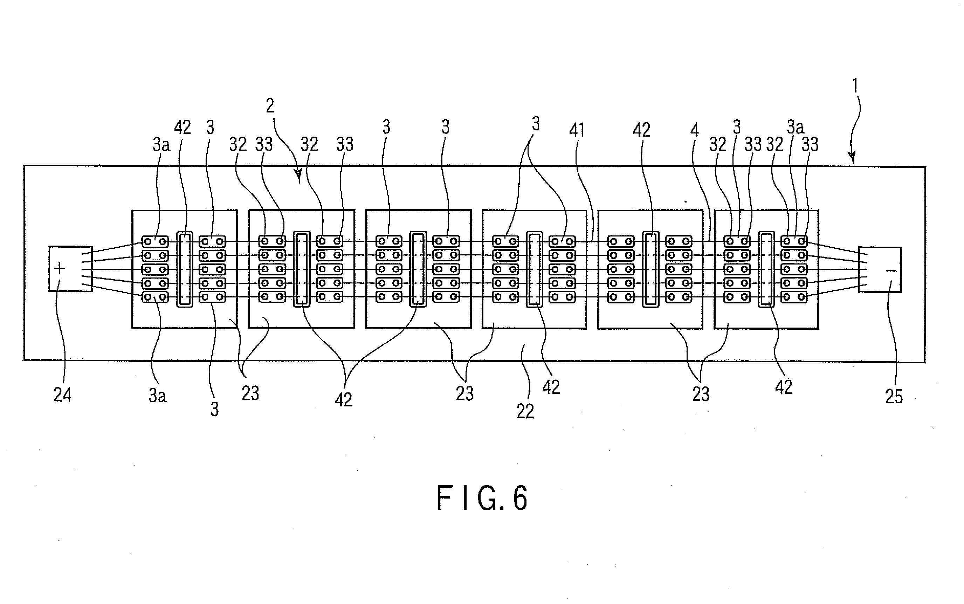

Next, a light-emitting device of a lighting apparatus according to a second embodiment will be explained with reference to FIGS. 5, 6 and 7. The same or equivalent parts as those in the first embodiment are given the same reference number, and an explanation thereof will be omitted.

In the second embodiment, a connection conductor 42 having a small area is provided, and electrodes of adjacent LED chips 3 are connected by a bonding wire 41 through the connection conductor 42. Therefore, a power supply wiring 4 comprises a connection conductor 42, and a bonding wire 41.

The connection conductor 42 is formed in the direction orthogonal to the extending direction of a line of LED chips 3, that is, between rows of five LED chips 3 in the longitudinal direction of the light-emitting device 1. The connection conductor 42 is formed narrow, and is configured in three layers similar to the radiation layer 23. The connection conductor 42 is separated from the radiation layer 23 with a predetermined space taken in the surrounding, and is electrically insulated from the radiation layer 23. As in the first embodiment, the radiation layer 23 is a non-conductive layer not electrically connected to other parts.

The connection conductor 42 is preferably formed to have an area smaller than at least the radiation layer 23, and minimal for connecting the bonding wire 41, to reduce a stray capacitance Cs.

The light-emitting elements 3 are connected as described below.

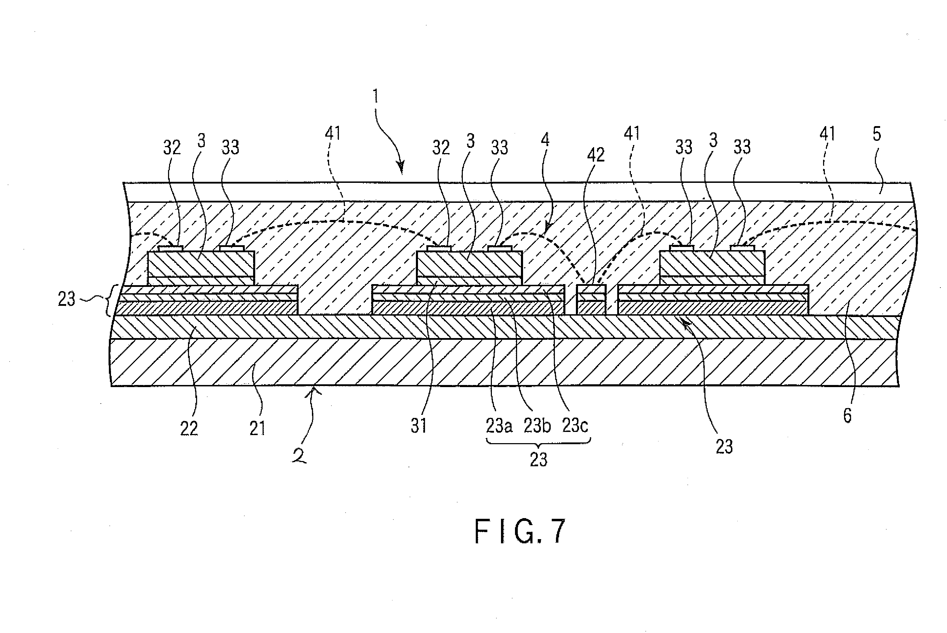

Different polarity electrodes of LED chips 3 adjacent in the extending direction of each line of LED chips, that is, as typically shown in FIG. 7, a positive electrode 32 of one LED chip 3 and a negative electrode 33 of the other LED chip 3 in two adjacent LED chips 3 on one radiation layer 23, are connected by the bonding wire 41 through the connection conductor 42. The negative electrode 33 of one LED chip 3 is directly connected to the positive electrode 32 of the opposite adjacent LED chip 3 by a bonding wire 41, and the positive electrode 32 of the other LED chip 3 is directly connected to the negative electrode 33 of the opposite adjacent LED chip 3 by a bonding wire 41.

As described above, according to this embodiment, similar to the first embodiment, a temperature increase in the LED chips 3 can be effectively prevented by increasing the area of the radiation layers 23, and erroneous lighting of the LED chips 3 can be prevented by decreasing the area of the power supply wiring 4.

Next, a lighting apparatus according to a third embodiment will be explained. The lighting apparatus can be configured with increased light amount by connecting a plurality of the above-described light-emitting device 1. Diagrammatic representation is omitted. In this case, it is proved that when two or more light-emitting device 1 are connected in series, a stray capacitance Cs is increased, a leakage current is increased, and the LED chip 3 tends to be erroneously lit. To solve the problem, the inventor has done various experiments. As a result, it is confirmed that when two or more light-emitting device 1 are connected in parallel, a leakage current flowing in each light-emitting device 1 can be equalized, and erroneous lighting can be prevented.

Therefore, when the lighting apparatus is configured by connecting two or more light-emitting devices 1, it is effective for preventing erroneous lighting to connect the light-emitting devices in parallel.

While certain embodiments have been described, these embodiments have been presented by way of example only, and are not intended to limit the scope of the embodiments. Indeed, the novel embodiments described herein may be embodied in a variety of other forms; furthermore, various omissions, substitutions and changes in the form of the embodiments described herein may be made without departing from the spirit of the embodiments. The accompanying claims and their equivalents are intended to cover such forms or modifications as would fall within the scope and spirit of the embodiments.

For example, the lighting apparatus is applicable to a lighting apparatus used indoor or outdoor, and a display. A light-emitting element is not limited to a light-emitting diode. Other light-emitting elements such as an EL element may be used.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A lighting apparatus **characterized by** comprising:
a conductive main body (8) at a ground potential;
a light-emitting device (1) in the main body, comprising a substrate (2) comprising an insulation layer (22), and a radiation layer (23) with a thermal conductivity, formed of conductive material and laminated on the insulation layer; a plurality of light-emitting elements (3) mounted on the radiation layer; and a power supply wiring (4) configured to electrically connect the light-emitting elements and to make the radiation layer electrically nonconductive; and
a lighting control device (7) configured to supply power to the light-emitting device.

2. The lighting apparatus of claim 1, **characterized in that** the power supply wiring (4) comprises a bonding wire (41) connecting electrodes (32, 33) of adjacent light-emitting elements (3).

3. The lighting apparatus of claim 1, **characterized in that** the power supply wiring (4) comprises a connection conductor (42) provided between adjacent light-emitting elements (3) and smaller than an area of at least the radiation layer (23), and bonding wires (41) connecting electrodes (32, 33) of adjacent light-emitting elements through the connection conductor (42).

4. The lighting apparatus of any of claims 1 to 3, **characterized in that** the radiation layer (23) is formed on the insulation layer (22) in two or more blocks arranged with intervals, and a plurality of light-emitting elements (3) is mounted on the radiation layer of each block.

5. The lighting apparatus of claim 4, **characterized in that** the power supply wiring (4) comprises bonding wires (41) connecting to electrodes (32, 33) of adjacent light-emitting elements (3).

6. The lighting apparatus of claim 4, **characterized in that** the power supply wiring (4) comprises a connection conductor (42) provided between adjacent light-emitting elements (3) on the radiation layer (23) of each block in being electrically insulated from the radiation layer, and bonding wires (41) directly connecting electrodes (32, 33) of adjacent light-emitting elements mounted on the radiation layers of different blocks.

7. The lighting apparatus of any one of claims 1 to 6, **characterized in that** the light-emitting device comprises:
a positive power supply conductor (24) and a negative power supply conductor (25), which are provided at both ends of the insulation layer (22), and are connected to the light-emitting elements (3) by the power supply wiring (4);
a frame member (5) configured to surround the light-emitting elements (3), and connecting portions of the positive power supply conductor and negative power supply conductor; and
a translucent sealing member (6) filled in the frame member to seal the light-emitting elements, the power supply wiring, and the connecting portions of the positive power supply conductor and negative power supply connector.

8. The lighting apparatus of claim 7, **characterized in that** the frame member (5) is formed of silicon resin.

9. The lighting apparatus of claim 7 or 8, **characterized in that** the sealing member (6) includes a fluorescent material.

10. The lighting apparatus of any of claims 7 to 9, **characterized in that** the radiation layer (23) comprises a surface layer (23c) on which the light-emitting elements (3) are mounted, and the surface layer is formed of a metal-plated layer.
